# EUROPÄISCHE PATENTSCHRIFT

(11) **EP 0 263 941 B1**
(45) Veröffentlichungstag und Bekanntmachung des Hinweises auf die Patenterteilung: **10.11.1993**
(21) Anmeldenummer: 87111909.5
(22) Anmeldetag: 17.08.1987
(51) Int. Cl.: H01L 27/10, H01L 21/82

(54) **Speicherzellenanordnung für dynamische Halbleiterspeicher**
Memory cell design for dynamic semiconductor memories
Configuration de cellules de mémoire pour mémoires dynamiques semi-conductrices

(30) Priorität: 16.10.1986 DE 3635293
(43) Veröffentlichungstag der Anmeldung: 20.04.1988
(73) Patentinhaber: SIEMENS AKTIENGESELLSCHAFT, 80333 München (DE)
(72) Erfinder: Risch, Lothar, Dr. Dipl.-Phys., D-8012 Ottobrunn (DE); Tielert, Reinhard, Dr. Ing., D-8000 München 82 (DE)

(56) Entgegenhaltungen:
- EP-A- 0 161 850
- EP-A- 0 191 612
- FR-A- 2 577 339

## Beschreibung

Die Erfindung betrifft eine Speicherzellenanordnung für dynamische Halbleiterspeicher nach dem Oberbegriff des Patentanspruchs 1.

Die Grundstruktur für die dynamischen Halbleiterspeicher auch DRAMs genannt, besteht aus einer Transistor/Kondensatorzelle. Der Transistor ist als MOS-FET konzipiert und ist über nach außen kontaktierte Source- und Gategebiete von außen steuerbar. Sein Draingebiet ist elektrisch mit einer Elektrodenseite des Kondensators verbunden, dessen zweite Elektrodenseite durch einen kontaktierten Anschluß von außen zu beeinflussen ist. Bei Packungsdichten von Transistoren- und Kondensatoren im 1 Megabitbereich werden die Kondensatoren meist planar ausgeführt, dies bedeutet, der Kondensator besteht aus einer dotierten Schicht des Substrats und einer planaren Polysiliziumschicht mit einer trennenden Dielektrikumsschicht. Zur Erhöhung der Packungsdichte bei dynamischen Speichern (DRAMs) sind aus Gründen der kleineren zur Verfügung stehenden Zellflächen und der aufgrund der Störsicherheit erforderlichen Kapazitätsgrößen von 30 bis 50 fF neue Überlegungen für die Ausgestaltung der Kondensatoren notwendig. Eine Möglichkeit diese Forderungen, also verringerter Platzbedarf und eine Mindestkapazität des Kondensators, besteht in dem Konzept den Kondensator als "stacked capacitor" aufzubauen. Der "stacked capacitor" besteht aus zwei Polysiliziumschichten mit einer trennenden Dielektrikumsschicht, die nicht mehr planar ausgebildet sind, sondern die Gateelektrode des Feldeffekttransistors überlappen.

Es ist bekannt, daß mit dem Konzept des "stacked capacitor" Speicherzellen für dynamische Halbleiterspeicher mit hoher Zellkapazität herstellbar sind, siehe IEEE Transaction on Electron Devices, Vol. ED-27, Nr. 8, August 1980, "A 5 V Only 16 kbit Stacked-Capacitor Mos Ram" von Mitsumasa Koyanagi, Yoshio Sakai, Masamichi Ishihara, Masanori Tazunoki und Norikazu Hashimoto (Seite 1596 bis Seite 1601). Ein "stacked capacitor" ist entsprechend dieser Veröffentlichung aus einer zweischichtigen Polysiliziumstruktur mit einer Siliziumnitridschicht Si₃N₄ (meist Poly Si-Si₃N₄-Poly Si oder Al) aufgebaut. In Figur 1 dieser Veröffentlichung werden drei "stacked capacitor" Zellstrukturen aufgeführt: A) "top capacitor", B) "intermediate capacitor" und C) "bottom capacitor". Bei den Ausführungsformen A und B werden die Gateelektroden vom "stacked capacitor" teilweise überlappt. Im Fall A ist die Dreischichtstruktur eine Poly Si-Si₃N₄-Al-Schicht im Fall B eine Poly Si-Si₃N₄ und wiederum eine Poly Si-Schicht. Im dritten Fall C dem "bottom capacitor" bedeckt die Gateelektrode teilweise den "stacked capacitor" der wiederum aus einer Poly Si-Si₃N₄-Poly Si-Struktur besteht.

In der Vergangenheit sind weitere Zellstrukturen zur Erhöhung des Integrationsgrades gefunden worden, wie beispielsweise die CCB-Zelle (capacitance-coupled Bit Line Zelle). Das Konzept einer CCB-Zelle ist in der Veröffentlichung des IEEE Journal of Solid State Circuits, Volume SC-20, Nr. 1, A Capacitance-Coupled Bit Line Cell von Masao Taguchi, Satoshi Ando, Shimpei Hijiya, Tetsuo Nakamura, Seiji Enomoto und Takashi Yabu (Seite 210 bis Seite 215) aufgeführt. Der Grundgedanke dieser Zelle liegt in einem kapazitiv gekoppelten Anschluß des Source-oder Draingebietes um den Bitleitungskontakt zum Substrat zu vermeiden. In Figur 1 dieser Veröffentlichung ist der Strukturaufbau näher erläutert, er besteht aus einer dreischichtigen Polysiliziumstruktur. Die erste Schicht bildet die Gateelektrode, die zweite und dritte Schicht den Kondensator mit einer trennenden Dielektrikumsschicht.

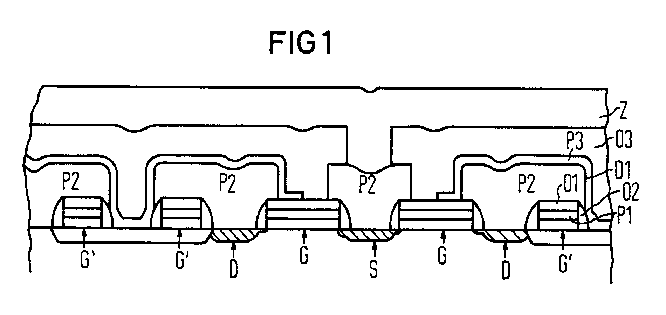

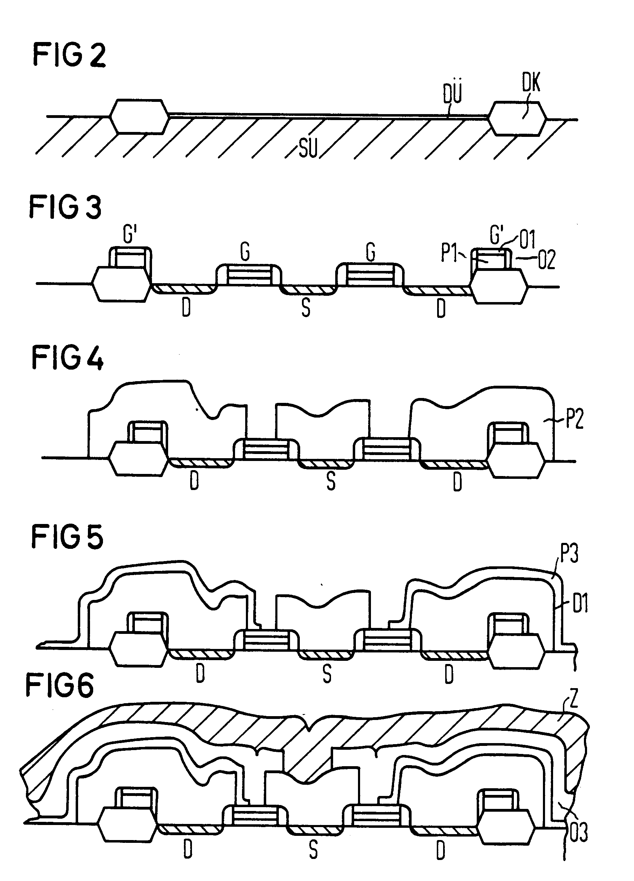

Eine andere Möglichkeit den Integrationsgrad zu erhöhen ist aus IEEE Electron Device Letters, Volume EDL-5, Nr. 5, May 1984, "A Three-Dimensional Folded Dynamic RAM in Beam-Recrystallized Polysilicon" von J. C. Sturm, M. D. Giles und J. F. Gibbons (Seite 151 bis Seite 153), bekannt. Hierbei wird die Transistor-Kondensatoranordnung dadurch komprimiert, daß ein Teil der einen Polysiliumschicht des Kondensators die andere u-förmig umfaßt und der Transistor über der zweiten Polysiliziumschicht des Kondensators angeordnet ist (siehe Figur 1 und Figur 2 der Veröffentlichung). Diese Anordnung wird auch als dynamische folded RAM-Zelle bezeichnet.

Beim Konzept der CCB Zelle befindet sich das Source oder Draingebiet zwischen den Anschlüssen des Transistors auf einfacher oder doppelter Betriebsspannung, was die Gefahr von Kurzschlüssen hervorruft. Dies ist besonders kritisch bei Kanallängen von 0,7 bis 1 µm der Transistoren.

Aus den beiden europäischen Anmeldeschriften EP-A-0 191 612 und EP-A-0 161 850 sowie aus der französischen Anmeldeschrift FR-A-2 577 339 ist eine Speicherzellenanordnung für dynamische Halbleiterspeicher auf einem dotierten Siliziumsubstrat bekannt, die aus
- mindestens einem Feldeffekttransistor mit
   - zwei als Source- und Draingebiete verwendeten Dotierungszonen,
   - einer allseitig mit Isolierschichten bedeckten Gateelektrode, die aus einer ersten dotierten Polysiliziumschicht besteht,
- mindestens einem Kondensator, der als "stacked capacitor" die Gateelektrode überlappt mit
   - einer zweiten dotierten und einer dritten dotierten Polysiliziumschicht
   - einer zwischen den Polysiliziumschichten befindlichen Dielektriumsschicht, wobei
      - die obere dritte Polysiliziumschicht die untere zweite Polysiliziumschicht einschließlich der Dielektrikumsschicht auf der Oberseite und an den Seitenflanken überlappt,
- einem Kontakt zwischen einer Zuleitung und einer ersten Dotierungszone, über ein Teilstück der zweiten Polysiliziumschicht, das isoliert zur zweiten Polysiliziumschicht des Kondensators ist
- einem Kontakt zwischen der zweiten dotierten Polysiliziumschicht des Kondensators und einer zweiten Dotierungszone besteht.

Nach den Konzepten der bisher bekannten "stacked capacitor" wird es bei einer Erhöhung der Integrationsdichte zunehmend schwieriger Kondensator und Bitleitungskontakte auszuführen.

Der Erfindung liegt die Aufgabe zugrunde, durch ein Zellkonzept der Speicherzellenanordnung die Integrationsdichte zu erhöhen, einfache Konstruktionsmöglichkeiten zwischen Zuleitung und Dotierungszone zu schaffen und durch ein einfaches Verfahren diese Speicherzellenanordnung herzustellen.

Diese Aufgabe wird erfindungsgemäß dadurch gelöst, daß die bei den obengenannten beiden europäischen Anmeldeschriften und der französischen Anmeldeschrift erwähnte zweite und dritte dotierte Polysiliziumschicht unterschiedlich dick sind und die zweite dotierte Polysiliziumschicht (P2) eine Dicke von 0,4 bis 1 µm und die dritte dotierte Polysiliziumschicht (P3) eine Dicke von etwa 0,15 µm besitzt.

Weitere Ausgestaltungen der Erfindung, insbesondere zu ihrer Realisierung ergeben sich aus den Unteransprüchen.

Die mit der Erfindung erzielten Vorteile bestehen insbesondere in einem Kapazitätsgewinn des Kondensators durch die größere Überlappungsflächen der zwei Polysiliziumschichten des Kondensators und in der Möglichkeit, den Kontakt der Zuleitung-Dotierungszone einfach auszuführen.
- In Figur 1: wird der Querschnitt einer erfindungsgemäßen Speicherzellenanordnung dargestellt und
- in den Figuren 2 bis 6: wird das Verfahren zur Herstellung der erfindungsgemäßen Speicherzellenanordnung näher beschrieben.

Die Speicherzellenanordnung in Figur 1 zeigt zwei Feldeffekttransitoren mit einem Source S, je einem Drain D und je einem Gatebereich G. Zwei zusätzliche Gateelektroden Gʹ, die auf dem Dickoxid aufgebracht sind, dienen als Zuleitung für die Feldeffekttransistoren der Nachbarzellen. Eine Gateelektrode G oder Gʹ ist allseitig mit Isolierschichten O1, O2 eingekapselt und weist in ihrem Innern eine dotierte Polysiliziumschicht P1 auf. Die Breite einer Gateelektrode beträgt 1,0 - 1,5 µm und die Breite der Source- und Draingebiete je ungefähr 1,2 µm. Das Teilstück der dotierten Polysiliziumschicht P2 über dem Sourcegebiet S dient als Kontakthilfsebene zwischen der Zuleitung Z und dem Sourcegebiet S. Diese Kontakthilfsebene kann die Gatestrukturen G überlappen. Die Teile der Polysiliziumschicht P2, die sich über den Draingebieten D befinden, bilden die unteren Kondensatorseiten der Kondensatoren. Sie stehen elektrisch über sogenannte "buried contacts" mit den zugehörigen Draingebieten D in Verbindung. Die Polysiliziumschicht wird mit einer relativ hohen Schichtdicke von 0,4 bis 1,0 µm abgeschieden. Die ca. 0,15 µm dicke Polysiliziumschicht P3 stellt die oberen Kondensatorseiten der Kondensatoren dar und ist zur Polysiliziumschicht P2 durch eine Dielektrikumsschicht D1 getrennt. Da die Polysiliziumschicht P3 die Seitenwände der Polysiliziumschicht P2 des Kondensators stets überlappt, addiert sich zur planaren Fläche die Fläche der Seitenwände des Kondensators und die Speicherkapazität erhöht sich um ca. 100 %. Da die Polysiliziumschicht P3 das Speicherzellenfeld ganzflächig bedeckt, müssen für die Kontakthilfsebenen der Polysiliziumschicht P2 Öffnungen in die Polysiliziumschicht P3 eingebracht werden, wobei ein Sicherheitsabstand zwischen Kontakthilfsebene und Polysiliziumschicht P3 von einer Justiertoleranz mit etwa 0,35 µm und einer Schichtdicke mit etwa 0,15 µm einzuhalten ist. Die Breite des Spaltes zwischen der Polysiliziumschicht P2 und einem als Kontakthilfsebene ausgebildeten Teilstück der Polysiliziumschicht P2 beträgt zweimal Schichtdicke Polysilizium P3 plus zweimal direkte Justiertoleranzen Polysiliziumschicht P3 zu Polysiliziumschicht P2, um zu gewährleisten, daß die Polysiliziumschicht P3 von der Kontakthilfsebene der Polysiliziumschicht P2 sicher entfernt ist, aber andererseits noch die untere Kondensatorseite allseitig bedeckt. Diese Breite unterteilt sich in drei Abstände, in einen Sicherheitsabstand von ca. 0,5 µm zwischen den Kontakthilfsebenen der Polysiliziumschicht P2 und der Polysiliziumschicht P3, in einen Abstand von ca. 0,35 µm als Überlappungsbreite der Polysiliziumschicht P3 über die Polysiliziumschicht P2 der Kondensatoren und in einen Abstand von ca. 0,15 µm als Schichtdicke der Polysiliziumschicht P3. Die Polysiliziumschicht P3 wird mit einer Isolationsschicht, vorzugsweise aus SiO₂, abgedeckt, in die Öffnungen geätzt sind. Durch diese Öffnungen, von ca. 0,9 µm Breite, wird der Kontakt zwischen der Zuleitung Z und dem Dotierungsgebiet, hier einem Sourcegebiet S hergestellt. Den Abschluß der Schichtenfolge bildet eine Aluminiumabdeckung als Zuleitung Z, die über die Kontakthilfsebene der Polysiliziumschicht P2 mit der Dotierungszone, hier einem Sourcegebiet S verbunden ist.

Im Bild 2 ist der erste Schritt des Prozeßablaufes zur Strukturierung der Speicherzellen angegeben, es handelt sich hierbei um die Strukturierung der Dick- DK und Dünnoxidbereiche DÜ auf dotiertem Siliziumsubstrat mit Hilfe der bekannten Locos-Technik.

Im zweiten Verfahrensschritt, dargestellt in Figur 3, werden die isolierten Gateelektroden G, Gʹ hergestellt. Es erfolgt die Abscheidung einer Polysiliziumschicht P1 ganzflächig auf dem dotierten Siliziumsubstrat. Danach wird eine Oxidschicht O1 auf der Polysiliziumschicht P1 abgeschieden. Mit Hilfe der Spacertechnik werden die Seitenflanken der Gateelektroden G, Gʹ mit einem Oxidmantel O2 eingekapselt. Die Spacertechnik besteht aus einem ganzflächiges Abscheiden von Siliziumoxid und einem anisotropes Zurückätzen, wobei an den Seitenflanken das Oxid stehen bleibt. Zum Abschluß werden die Source- S und Draingebiete D dotiert. Die Gateelektroden G bilden gemeinsam mit den Drain D und Sourcegebieten S zwei Feldeffekttransistoren, während die Gateelektroden Gʹ für Zuleitungen von weiteren, hier nicht eingezeichneten Feldeffekttransistoren dienen.

In Figur 4 wird die Strukturierung der zweiten Polysiliziumschicht P2 für den "stacked capacitor" und für die Kontakthilfsebenen dargestellt. Es wird eine 0,4 bis 1,0 µm dicke Polysiliziumschicht P2 abgeschieden und anschließend mit einer Maske über einen Ätzvorgang die untere Kondensatorseite für den "stacked capacitor" und für die Kontakthilfsebenen herausgeätzt. Anschließend wird eine Siliziumnitrid Si₃N₄ durch einen CVD-Prozeß oder eine SiO₂-Schicht durch einen Oxidationsprozeß als Dielektrikumsschicht zwischen der Polysiliziumschicht P2 und der später aufzubringenden Polysiliziumschicht P3 der Kondensatoren erzeugt.

In Figur 5 ist die Strukturierung der dünnen Polysiliziumschicht P3 für den "stacked capacitor" angegeben.

Hierzu wird eine dünne Polysiliziumschicht P3 abgeschieden und mit Hilfe einer Maske und eines Ätzvorganges diese Schicht über den Kontakthilfsebenen und Teilen der Gateelektroden G wieder weggeätzt.

Figur 6 zeigt den Abschluß des Prozeßablaufs zur Herstellung der erfindungsgemäßen Speicherzellen. Es wird eine ca. 0,6 bis 0,8 µm dicke SiO₂-Schicht O3 durch einen CVD-Prozeß erzeugt und mit Hilfe einer Maske und eines weiteren Ätzvorganges werden Öffnungen in diese SiO₂-Schicht eingelassen, wo im weiteren Prozeßablauf ein Kontakt zwischen der Zuleitung Z und dem Sourcegebiet S über die Kontakthilfsebenen der Polysiliziumschicht P2 hergestellt wird. Der Abschluß des Prozeßablaufes bildet das Auftragen der Aluminiumschicht als Zuleitung Z, die über die Kontakthilfsebenen der Polysiliziumschicht P2 mit den Sourcegebieten S der Feldeffektransistoren verbunden wird.

## Patentansprüche

1. Speicherzellenanordnung für dynamische Halbleiterspeicher auf einem dotierten Siliziumsubstrat bestehend aus
- mindestens einem Feldeffekttransistor mit
- zwei als Source- (S) und Draingebiete (D) verwendeten Dotierungszonen
- einer allseitig mit Isolierschichten bedeckten Gateelektrode (G), die aus einer ersten dotierten Polysiliziumschicht (P1) besteht
- mindestens einem Kondensator, der als "stacked capacitor", die Gateelektrode (G) überlappt mit
- einer zweiten dotierten (P2) und einer dritten dotierten Polysiliziumschicht (P3)
- einer zwischen den Polysiziliumschichten befindlichen Dielektrikumsschicht (D1), wobei
- die obere dritte Polysiliziumschicht (P3) die untere zweite Polysiliziumschicht (P2) einschließlich der Dielektrikumsschicht (D1) auf der Oberseite und an den Seitenflanken überlappt
- einem Kontakt zwischen einer Zuleitung (Z) und einer ersten Dotierungszone über ein Teilstück der zweiten Polysiliziumschicht P2, das isoliert zur zweiten Polysiliziumschicht des Kondensators ist
- einem Kontakt zwischen der zweiten dotierten Polysiliziumschicht (P2) des Kondensators und einer zweiten Dotierungszone,
**dadurch gekennzeichnet,**
daß die zweite dotierte Polysiliziumschicht (P2) eine Dicke von 0,4 bis 1 µm und die dritte dotierte Polysiliziumschicht (P3) eine Dicke von etwa 0,15 µm besitzt.

2. Speicherzellenanordnung nach Anspruch 1, **dadurch gekennzeichnet,** daß die dritte Polysiliziumschicht (P3) ein Speicherzellenfeld abdeckt, welches aus vielen Kondensatoren und Feldeffekttransistoren besteht und daß die dritte Polysiliziumschicht (P3) Öffnungen für das Teilstück der zweiten Polysiliziumschicht enthält, über die der Kontakt zwischen Zuleitung (Z) und Dotierungszone hergestellt wird.

3. Speicherzellenanordnung nach Anspruch 1 oder 2, **dadurch gekennzeichnet,** daß das Teilstück der zweiten Polysiliziumschicht die allseitig mit Isolierschichten bedeckte Gateelektrode (G) teilweise überlappt.

4. Verfahren zum Herstellen einer Speicherzellenanordnung nach Anspruch 3, **gekennzeichnet durch** den Ablauf der folgenden Schritte:
a) es werden auf dotiertem Siliziumsubstrat Dick- (DK) und Dünnoxidbereiche (DÜ) strukturiert,
b) es werden die isolierten Gateelektroden (G) strukturiert und unter Anwendung der Spacertechnik auf die Gateelektroden werden die Seitenflächen mit einem Oxidmantel (O2) eingekapselt und "buried contacts" im Bereich des Teilstücks der zweiten Polysiliziumschicht zur ersten Dotierungszone und im Bereich der zweiten Polysiliziumschicht (P2) des Kondensators zur zweiten Dotierungszone hergestellt,
c) es werden die Source- (S) und Draingebiete (D) für den Feldeffekttransistor dotiert,
d) es wird eine 0,5 bis 1,0 µm dicke zweite dotierte Polysiliziumschicht (P2) so strukturiert, daß sie das Teilstück der zweiten Polysiliziumschicht und die zweite Polysiliziumschicht (P2) des Kondensators bildet,
e) es wird eine Dielektrikumsschicht (D1) als Isolationszwischenschicht für den Kondensator aufgetragen,
f) es wird die dritte dünne dotierte Polysiliziumschicht (P3) für den Kondensator strukturiert,
g) es wird eine Isolationsschicht aufgetragen und der Kontakt zwischen der Zuleitung (Z) und der ersten Dotierungszone wird hergestellt.

## Claims

1. Memory cell design for dynamic semiconductor memories on a doped silica substrate, which design comprises
- at least one field-effect transistor having
- two doped zones used as source (S) and drain (D) regions,
- a gate electrode (G) which is covered on all sides by insulating layers and which comprises a first doped polysilicone layer (P1),
- at least one capacitor which overlaps the gate electrode (G) as "stacked capacitor", having
- a second doped (P2) and a third doped (P3) polysilicone layer, and
- a dielectric layer (D1) situated between the polysilicone layers,
- the upper, third polysilicone layer (P3) overlapping the lower, second polysilicone layer (P2), including the dielectric layer (D1) on the upper side and at the side edges,
- a contact between a supply conductor (Z) and a first doped zone via a component of the second polysilicone layer (P2) which is insulated from the second polysilicone layer of the capacitor,
- a contact between the second doped polysilicon layer (P2) of the capacitor and a second doped zone,
characterised in that the second doped polysilicone layer ((P2) has a thickness of 0.4 to 1 µm and the third doped polysilicone layer (P3) has a thickness of about 0.15 µm.

2. Memory cell design according to Claim 1, characterised in that the third polysilicone layer (P3) covers a memory cell array which comprises a multiplicity of capacitors and field-effect transistors, and in that the third polysilicone layer (P3) contains openings for the component of the second polysilicone layer, via which the contact between supply conductor (Z) and doped zone is made.

3. Memory cell design according to Claim 1 or 2, characterised in that the component of the second polysilicone layer partially overlaps the gate electrode (G) which is covered on all sides by insulating layers.

4. Process for producing a memory cell design according to Claim 3, characterised by the performance of the following steps:
a) thick-oxide (DK) and thin-oxide (DU) regions are patterned on a doped silicone substrate,
b) the insulated gate electrodes (G) are patterned and the side surfaces are encapsulated with an oxide cladding (O2) using the spacer technique, and "buried contacts" are made to the first doped zone in the region of the component of the second polysilicone layer and to the second doped zone in the region of the second polysilicone layer (P2) of the capacitor,
c) the source (S) and drain (D) regions for the field-effect transistor,
d) a second doped polysilicone layer (P2) 0.5 to 1.0 µm thick is patterned in such a way that it forms the component of the second polysilicone layer and the second polysilicone layer (P2) of the capacitor,
e) a dielectric layer (D1) is applied as insulating interlayer for the capacitor,
f) the third, thin, doped polysilicone layer (P3) is patterned for the capacitor,
g) an insulating layer is applied and the contact is made between the supply conductor (Z) and the first doped zone.

## Revendications

1. Dispositif de cellule de mémoire pour des mémoires dynamiques à semiconducteurs sur un substrat en silicium dopé, constitué par
- au moins un transistor à effet de champ comportant
- deux zones de dopage utilisées en tant que région de source (S) et région de drain (D),
- une électrode de grille (G), qui est recouverte de tous côtés par des couches isolantes et est constituée par une première couche de polysilicium dopée (P1),
- par au moins un condensateur, qui recouvre, en tant que "stacked capacitor", l'électrode de grille (G) et comprend
- une seconde couche de polysilicium dopée (P2) et une troisième couche de polysilicium dopée (P3),
- une couche diélectrique (D1) située entre les deux couches de polysilicium,
- la troisième couche supérieure de polysilicium (P3) recouvrant la seconde couche inférieure de polysilicium (P2) y compris la couche diélectrique (D1) au niveau de la face supérieure et des flancs latéraux,
- un contact entre un conducteur d'alimentation (Z) et une première zone de dopage par l'intermédiaire d'un élément de la seconde couche de polysilicium (P2), qui est isolé par rapport à la seconde couche de polysilicium du condensateur,
- un contact entre la seconde couche de polysilicium dopée (P2) du condensateur et une seconde zone de dopage,
caractérisé par le fait que la seconde zone de polysilicium dopé (P2) possède une épaisseur comprise entre 0,4 et 1 µm et la troisième couche de polysilicium dopé (P3) possède une épaisseur égale à environ 0,15 µm.

2. Dispositif de cellule de mémoire suivant la revendication 1, caractérisé par le fait que la troisième couche de polysilicium (P3) recouvre une zone de cellules de mémoire, qui est constituée par de multiples condensateurs et transistors à effet de champ, que la troisième couche de polysilicium (P3) possède, pour l'élément de la seconde couche de polysilicium, des ouvertures, au moyen desquelles le contact est établi entre un conducteur d'alimentation (Z) et une zone de dopage.

3. Dispositif de cellule de mémoire suivant la revendication 1 ou 2, caractérisé par le fait que l'élément de la seconde couche de polysilicium recouvre en partie l'électrode de grille (G), qui est recouverte des deux côtés par des couches isolantes.

4. Procédé pour fabriquer un dispositif de cellule de mémoire suivant la revendication 3, caractérisé par l'exécution des étapes suivantes :
a) on structure des régions d'oxyde épais (DK) et des régions d'oxyde mince (DÜ) sur un substrat en silicium dopé,
b) on structure les électrodes de grille isolées (G) et, en utilisant la technique des entretoises (spacer) sur les électrodes de grille, on encapsule les faces latérales avec une enveloppe d'oxyde (O2) et on fabrique des "burried contacts" (contacts ensevelis) dans la région de l'élément de la seconde couche de polysilicium jusqu'à la première zone de dopage et, dans la région de la seconde couche de polysilicium (P2) du condensateur, jusqu'à la seconde zone de dopage,
c) on dope les régions de source (S) et de drain (D) pour le transistor à effet de champ,
d) on structure une seconde couche de polysilicium dopé (P2) possédant une épaisseur comprise entre 0,5 et 1,0 µm de manière qu'elle forme l'élément de la seconde couche de polysilicium et la seconde couche de polysilicium (P2) du condensateur,
e) on dépose une couche diélectrique (D1) en tant que couche intercalaire isolante pour le condensateur,
f) on structure la troisième couche mince de polysilicium dopé (P3) pour le condensateur,
g) on dépose une couche isolante et on forme le contact entre le conducteur d'alimentation (Z) et la première zone de dopage.
